Europäisches Patentamt

**European Patent Office**

**Office européen des brevets**

(11) Publication number: **0 167 810**

A1

(12) # EUROPEAN PATENT APPLICATION

(21) Application number: **85106859.3**

(22) Date of filing: **04.06.85**

(51) Int. Cl.⁴: **H 01 L 29/80**
**H 01 L 29/10**

(30) Priority: **08.06.84 US 618434**

(43) Date of publication of application:
**15.01.86 Bulletin 86/3**

(84) Designated Contracting States:
**DE FR GB NL**

(71) Applicant: **EATON CORPORATION**
**Eaton Center 111 Superior Ave.**
**Cleveland Ohio 44114(US)**

(72) Inventor: **Benjamin, James Anthony**
**20865 Hawthorne Ridge Court**
**Waukesha Wisconsin 53186(US)**

(72) Inventor: **Lade, Robert Walter**
**1009 North Jackson Street Apartment 2302**
**Milwaukee Wisconsin 43202(US)**

(72) Inventor: **Schutten, Herman Peter**
**8545 North Fielding Road**
**Bayside Wisconsin 53217(US)**

(74) Representative: **Wagner, Karl H.**
**WAGNER & GEYER Patentanwälte**
**Gewuerzmuehlstrasse 5 Postfach 246**
**D-8000 München 22(DE)**

(54) **Power JFET with plural lateral pinching.**

(57) A power JFET (2) has a row (4) of alternating conductivity type layers (6-16) forming a plurality of channels (7, 9, 11, 13 and 15). The JFET has an ON state conducting bidirectional current horizontally longitudinally through the channels. The JFET has an OFF state blocking current flow through the channels due to horizontally lateral depletion pinch-off. Main and gate terminal and depletion region structure is disclosed for row layers extending vertically and horizontally longitudinally such that the direction of layering in the row extends horizontally laterally.

FIG.I

## Background And Summary

The invention relates to a junction field effect transistor (JFET) affording high blocking voltage capability, including AC application.

A power JFET is provided having a row of alternating conductivity type layers forming a plurality of channels. Bidirectional current is conducted horizontally longitudinally through the channels in an ON state. Multiple channels reduce the channel component of the ON state resistance. In the OFF state, current flow is blocked by horizontally lateral depletion region spreading and pinch-off in the channels.

In preferred form, a horizontally longitudinally extending drift region of like conductivity type as the channels is provided at one or both ends of the channels such that bidirectional current is conducted horizontally longitudinally through the channels and through the drift region. Linear geometry enables desirable control of breakdown voltage, and in turn a higher blocking voltage capability. Conduction current through the drift region affords desirable bulk effect characteristics.

## Description Of The Drawings

FIG. 1 is a schematic isometric view showing power JFET structure constructed in accordance with the invention.

FIGS. 2-4 are sectional views taken along line 4-4 of FIG. 1, and illustrate sequential processing steps for forming the structure thereof.

FIG. 5 is an enlarged isolated section of FIG. 4 illustrating a conduction channel, and depletion pinch-off.

FIG. 6 is an isometric illustration showing the preferred gate terminal structure.

## Description Of The Invention

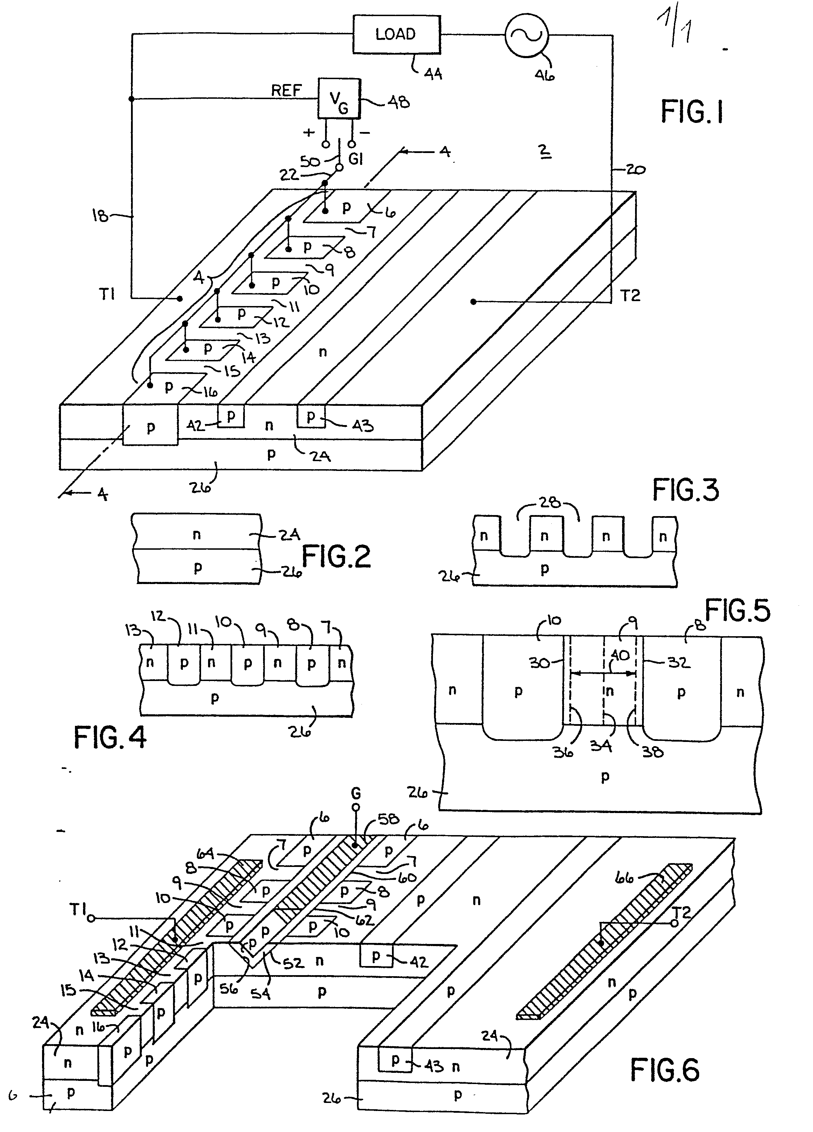

FIG. 1 shows a power JFET 2 having a row 4 of alternating conductivity type layers such as 6-16 forming a plurality of channels such as 7, 9, 11, 13 and 15. JFET 2 has an ON state conducting bidirectional current horizontally longitudinally through the channels. JFET 2 has an OFF state blocking current flow through the channels due to horizontally lateral depletion region spreading and pinch-off. The layers 6-16 of row 4 extend vertically and horizontally longitudinally such that the direction of layering extends horizontally laterally.

Channels 7, 9, 11, 13 and 15 are of one conductivity type, such as n type. First main terminal means T1 is operatively coupled to one end of the channels in the row, as shown at connection 18 at the left end in FIG. 1. Second main terminal means T2 is operatively coupled to the other end of the channels in the row, as shown at right end connection 20 in FIG. 1. Gate terminal means G is operatively coupled to the other conductivity type layers such as layers 6, 8, 10, 12, 14, and 16 in row 4, as shown at 22. In preferred form, a drift region 24 of the one conductivity type, such as n type, extends horizontally laterally the length of row 4 and also extends horizontally longitudinally between and separating row 4 and second main terminal means T2, such that in the noted ON state bidirectional current flows horizontally longitudinally through the channels and through drift region 24 between main terminal means T1 and T2. An extended drift region may also be provided on the left between row 4 and main terminal means T1.

Referring to FIGS. 2-4, the formation of JFET 2 is initiated with a substrate such as p type layer 26, followed by epitaxial growth of n type layer 24 which will eventually provide the drift region 24 and the channels 7, 9, 11, 13 and 15. A plurality of notches such as 28, FIG. 3, are then formed by anisotropic etching, plasma etching, or other suitable means, as known in the art; C. Hu "A Parametric Study of Power MOSFETs", IEE Electron Device Conference, Paper CH1461-3/79, 0000-0385; IEE Electron Devices, Volume ED-25, No. 10, October, 1978; and Ammar and Rogers, "UMOS Transistors on Silicon", Transactions IEEE, ED-27, pages 907-914, May, 1980. Alternatively, the notches may be formed by a porous silicon region in accordance with the known annodization technique of passing a fixed current through the localized region in the presence of concentrated hydrogen flouride to create a structural change in the silicon which remains single crystalline with the substrate but becomes porous. The notches then etch at a much faster rate. A p deposition in the notch yields the structure of FIG. 4, taken along line 4-4 of FIG. 1, with alternating conductivity type layers 7-13 and so on of row 4.

Referring to FIG. 5, depletion region spreading from the junctions such as 30 and 32 between the layers of the row cause the noted pinch-off OFF state. When the depletion region spreading rightwardly from junction 30 meets the depletion region spreading leftwardly from junction 32, as shown at dashed line interface 34, channel 9 is pinched-off. In this OFF state, current cannot flow through channel 9 into or out of the page in the orientation of FIG. 5, which is horizontally longitudinal in the orientation of FIG. 1. The depletion region spreading direction in FIG. 5 is left-right, which is horizontally lateral in FIG. 1.

Depletion region shrinking toward the junctions between the layers in the row enables the noted ON state. For example, in FIG. 5, depletion region shrinking leftwardly toward junction 30, as shown at dashed line 36, and depletion region shrinking rightwardly toward junction 32, as shown at 38, opens a conductive region of width 40 through channel 9. Current may flow into or out of the page in FIG. 5, which is horizontally longitudinal through the channels in FIG. 1.

During the etched p deposition processing step for regions 7, 9 and so on, additional etched p deposition regions 42, 43 may be formed to yield field shaping means in drift region 24. One or more p regions 42, 43 extend horizontally laterally across the top surface of epitaxial drift region layer 24 between and parallel to row 4 and terminal T2. Field shaping regions 42, 43 are removed from the active area of the channel junctions between the layers of row 4. These field shaping regions straighten field lines in drift region 24 and reduce gradient curvature crowding of the field lines, whereby to increase blocking voltage capability. In preferred form, the field shaping means is provided by one or more floating depletion regions 42, 43 not tied to any source of bias potential. For example, depletion region 42 is vertically opposed to a portion of p type substrate 26 therebelow; and region 42 and the vertically opposed portion of substrate 26 form field shaping p type depletion regions vertically opposed in n type drift region 24 for straightening field lines therebetween in the drift region.

FIG. 1 shows power JFET 2 connected in an AC load line, including load 44 and AC power source 46. In the ON state, during the first half cycle of AC source 46, current flows rightwardly through JFET 2, namely from left main terminal T1 through conduction channels 7, 9, 11, 13 and 15, through drift region 24 to right main terminal T2, to complete a circuit through load 44. In the other half cycle of AC source 46, current flows leftwardly through JFET 2, namely from right main terminal T2, through drift region 24, through conduction channels 7, 9, 11, 13 and 15 to left main terminal T1.

In the preferred embodiment, JFET 2 is normally OFF. The depletion regions from p layers such as 8 and 10, FIG. 5, normally extend toward and meet each other, as at 34, in the absence of bias on the gate terminal, such that the channels such as 9 are normally pinched-off. JFET 2 is turned ON by biasing gate terminal G to shrink the depletion regions and open conductive channels, such as 40, FIG. 5, such that current can flow between main terminals T1 and T2. Gating voltage source 48 is referenced to main terminal T1 and provides the relatively positive gate bias when switch 50 is in its leftward position. Referring to FIG. 5, junctions 30 and 32 are then forward biased, and the depletion regions in layer 9 shrink toward the junctions to open the conductive channel of width 40. In one form of this embodiment, the horizontal length of drift region 24 between row 4 and terminal T2 is about 60 microns. The lateral horizontal width of the n type channel layers such as 9 is about 3,000-5,000 angstroms. The lateral horizontal width of the p layers such as 8 is arbitrary according to processing. The n type regions have a concentration of about $10^{14}$ or about $10^{15}$ atoms per cubic centimeter, and the concentration of the p type regions is about $10^{17}$ or $10^{18}$ atoms per cubic centimeter.

In an alternate embodiment, JFET 2 is normally ON. The depletion regions from the p type layers, such as 8 and 10 in FIG. 5, normally extend only partially towards each other, as shown at 38 and 36, in the absence of gate bias, to leave open conductive channel 9, as shown at 40, such that current can flow between main terminals T1 and T2. JFET 2 is turned OFF by biasing gate terminal G to spread the depletion regions and pinch-off the channels, as shown at 34, FIG. 5. With switch 50 in its rightward position, a relatively negative gate bias is applied, to thus reverse bias the junctions between the layers in row 4. For example, reverse biasing of junctions 30 and 32, FIG. 5, spreads the depletion regions to pinch-off the channel, as shown at 34.

Referring to FIG. 6, a groove 52 is notched vertically into row 4. Groove 52 may be V-shaped or U-shaped, and formed by the above noted anistropic etching, plasma etching, or other suitable means. The gate terminal means is in groove 52 and connected to the other conductivity type layers, such as p layers 6, 8, 10, 12, 14 and 16, in row 4. The gate terminal means includes a first gate layer of semiconductor material of the other conductivty type, such as p layer 54, extending along the inner surface 56 of groove 52 to contact p layers 6, 8, 10, 12, 14 and 16. The gate terminal means also includes a gate electrode 58 contacting gate layer 54. Groove 52 extends horizontally laterally and transversely across the layers 6-16 of row 4.

P type gate layer 54 is contiguous with and forms a plurality of interface junctions such as 60 and 62 along the channels such as 7 and 9 in row 4. The

-7-

last mentioned junctions such as 60 and 62 have a forward voltage drop thereacross great enough to prevent shorting of junctions such as 30 and 32, FIG. 5, between the layers of row 4. This ensures a sufficient voltage differential across the channel junctions such as 30 and 32 to enable depletion region shrinking toward the junctions such as 30 and 32, enabling the noted ON state. The voltage drop across the groove junctions such as 60 and 62 and across the channel junctions such as 30 and 32 is typically about 0.7 volts, due to the noted carrier concentrations, which are likewise used for p layer 54.

The left main terminal means is provided by an electrode 64 contacting layer 24 to thus be connected to the left end of channels 7, 9, 11, 13 and 15 in row 4. The right main terminal means is provided by an electrode 66 contacting layer 24 to thus be connected to the right end of channels 7, 9, 11, 13 and 15 in row 4. Electrodes 58, 64 and 66 are preferably aluminum or polysilicon.

It is recognized that various alternatives are possible within the scope of the appended claims.

## CLAIMS

1. A power JFET having a row of alternating conductivity type layers forming a plurality of channels, said JFET having an ON state conducting bidirectional current horizontally longitudinally through said channels, said JFET having an OFF state blocking current flow through said channels due to horizontally lateral depletion pinch-off.

2. The invention according to claim 1 wherein said layers of said row extend vertically and horizontally longitudinally, and the direction of layering extends horizontally laterally.

3. The invention according to claim 2 wherein said channels are of one conductivity type, and comprising:

first main terminal means operatively coupled to one end of said channels in said row;

second main terminal means operatively coupled to the other end of said channels in said row;

gate terminal means operatively coupled to the other conductivity type layers in said row;

depletion region spreading from the junctions between said layers causing said pinch-off OFF state;

depletion region shrinking toward the junctions between said layers enabling said ON state.

4. The invention according to claim 3 comprising a drift region of said one conductivity type between said second main terminal means and said row such that current between said first and second main terminal means traverses horizontally longitudinally through said channels and said drift region.

5. The invention according to claim 4 wherein said drift region comprises a horizontally longitudinally and laterally extending expitaxial layer of said one conductivity type on a substrate of said other conductivity type, said row of alternating conductivity type layers being formed by a plurality of laterally aligned notches extending downwardly into and through said epitaxial layer and into said substrate and containing semiconductor material of said other conductivity type defining said channels therebetween in said expitaxial layer.

6. The invention according to claim 3 wherein:

said JFET is normally OFF;

the depletion regions from said other conductivity type layers in said row normally extend toward and meet each other in said channels in the absence of bias on said gate terminal means, such that said channels are normally pinched-off;

said JFET being turned ON by biasing said gate terminal means to shrink said depletion regions and open conductive said channels therebetween such that current can flow between said main terminal means.

7. The invention according to claim 3 wherein:

said JFET is normally ON;

the depletion regions from said other conductivity type layers in said row normally extend only partially toward each other to leave open conductive said channels therebetween such that current can flow between said main terminal means;

said JFET being turned OFF by biasing said gate terminal means to spread said depletion regions and pinch-off said channels.

8. The invention according to claim 4 comprising field shaping means in said drift region removed from the active area of said junctions.

9. The invention according to claim 8 wherein said field shaping means comprises one or more regions of said other conductivity type for straightening field lines in said drift region and reducing gradient curvature crowding of said field lines whereby to increase blocking voltage capability.

10. A power JFET comprising:

a row of alternating conductivity type layers forming a plurality of channels of one conductivity type extending vertically and horizontally longitudinally such that the direction of layering extends horizontally laterally, said JFET having an ON state conducting bidirectional current horizontally longitudinally through said channels, said JFET having an OFF state blocking current flow through said channels due to horizontally lateral depletion pinch-off;

first main terminal means operatively coupled to one end of said channels in said row;

second main terminal means operatively coupled to the other end of said channels in said row;

gate terminal means operatively coupled to the other conductivity type layers in said row;

depletion region spreading from the junctions between said layers causing said pinch-off OFF state;

depletion region shrinking toward the junctions between said layers enabling said ON state.

11. The invention according to claim 10 comprising a drift region of said one conductivity type semiconductor material extending longitudinally between and separating said second main terminal means and said row such that in said ON state current flows horizontally longitudinally through said channels and said drift region.

12. The invention according to claim 11 comprising field shaping depletion regions of said other conductivity type vertically opposed in said drift region for straightening field lines therebetween.

13. A power JFET comprising:

a row of alternating conductivity type layers forming a plurality of channels of one conductivity type, said JFET having an ON state conducting bidirectional current horizontally longitudinally through said channels, said JFET having an OFF state blocking current flow through said channels due to horizontally lateral depletion pinch-off;

a groove notched vertically into said row;

gate terminal means in said groove connected to the other conductivity type layers in said row;

first main terminal means operatively coupled to one end of said channels in said row;

second main terminal means operatively coupled to the other end of said channels in said row;

depletion region spreading from the junctions between said layers causing said pinch-off OFF state;

depletion region shrinking toward the junctions between said layers enabling said ON state.

14. The invention according to claim 13 wherein said gate terminal means comprises:

a gate layer of semiconductor material of said other conductivity type extending along the inner surface of said groove to contact said other conductivity type layers in said row; and

a gate electrode contacting said gate layer.

15. The invention according to claim 14 wherein:

said layers of said row extend vertically and horizontally longitudinally, and the direction of layering extends horizontally laterally;

said groove extends horizontally laterally and transversely across the layers of said row;

said gate layer is contiguous with and forms a plurality of interface junctions along said channels in said row, said last mentioned junctions having a forward voltage drop thereacross great enough to prevent shorting of said junctions between said layers of said row so as to ensure a sufficient voltage differential across said last mentioned junctions to enable said depletion reigon shrinking toward said last mentioned junctions enabling said ON state.

FIG.1

FIG.2

FIG.3

FIG.4

FIG.5

FIG.6

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | FR-A-2 152 656 (PHILIPS)<br><br>* Page 9, line 17 - page 10, line 9; page 13, line 25 - page 15, line 27; figures 7-9 * | 1-3,6, 7,10 | H 01 L 29/80<br>H 01 L 29/10 |
| A |  | 5,13-15 |  |
| X | FR-A-1 306 187 (WESTINGHOUSE)<br>* Page 1, column 1, line 7 - page 2, column 1, line 24; figure 3 * | 1-3,10 |  |
| A |  | 5-7,13-15 |  |
| X | DE-A-3 345 189 (OLYMPUS)<br>* Figures 3A,3B; page 8, line 5 - page 9, line 8 * | 1-3,10 | TECHNICAL FIELDS SEARCHED (Int. Cl.4) |
| A |  | 4-7,13-15 | H 01 L |
| X | FR-A-1 377 330 (TESZNER)<br>* Page 2, column 2, lines 4-49; figures 3-6 * | 1-3,10 |  |
| A |  | 6,7,13-15 |  |

--- -/-

The present search report has been drawn up for all claims

| Place of search | Date of completion of the search | Examiner |
|---|---|---|
| THE HAGUE | 29-08-1985 | GELEBART J.F.M. |

European Patent Office

| Category | Citation of document with indication, where appropriate, of relevant passages | Relevant to claim | CLASSIFICATION OF THE APPLICATION (Int Cl.4) |
|---|---|---|---|
| X | FR-A-2 454 703 (NIPPON TELEGRAPH & TELEPHONE PUBLIC CORP.) <br> * Figures 1-4; page 6, line 34 - page 11, line 11 * | 1-3,10 | |
| A | | 6,7,13 | |
| X | DE-A-2 728 532 (SIEMENS) <br> * Page 4, line 18 - page 5, line 22; figures 1,2 * | 1-3,10 | |
| A | | 6,7,13 | |
| X,A | JAPANESE JOURNAL OF APPLIED PHYSICS, vol. 20, suppl. 20-1, 1981, pages 235-239, Tokyo, JP; K. ASAI et al.: "P-column gate field effect transistor" <br> * Paragraphs 2-4; figures 1,2 * | 1-3,6, 10 | TECHNICAL FIELDS SEARCHED (Int. Cl.4) |
| A | EP-A-0 083 815 (PHILIPS) <br> * Figure 2; page 6, line 28 - page 7, line 2; page 10, lines 14-28 * | 4,8,9, 11 | |
| A | EP-A-0 053 854 (PHILIPS) <br> * Figures 4,5; page 21, line 5 - page 23, line 30 * | 13-15 | |

**DOCUMENTS CONSIDERED TO BE RELEVANT**

The present search report has been drawn up for all claims

| Place of search | Date of completion of the search | Examiner |
|---|---|---|
| THE HAGUE | 29-08-1985 | GELEBART J.F.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82